# FASCICULE DE BREVET EUROPEEN

(11) **EP 2 057 874 B1**
(45) Date de publication et mention de la délivrance du brevet: **28.09.2011**
(21) Numéro de dépôt: 07819968.4
(22) Date de dépôt: 27.08.2007
(51) Int. Cl.: H05K 7/20

(54) **BAIE ELECTRONIQUE ASSOCIANT CONVECTION NATURELLE ET CIRCULATION D'AIR FORCE POUR SON REFROIDISSEMENT**
ELEKTRONISCHER BAUGRUPPENTRÄGER MIT NATÜRLICHER KONVEKTION UND ZWANGSBELÜFTUNG ZUR KÜHLUNG
ELECTRONIC RACK HAVING NATURAL CONVECTION AND CIRCULATION OF FORCED AIR FOR COOLING IT

(30) Priorité: 30.08.2006 FR 0607628
(43) Date de publication de la demande: 13.05.2009
(73) Titulaire: THALES, 92200 Neuilly sur Seine (FR)
(72) Inventeur: NEMOZ, Gérard, F-94700 Maisons Alfort (FR); BELLIN, Bruno, 91370 Verrières le Buisson (FR)
(74) Mandataire: Esselin, Sophie
(86) Numéro de dépôt international: PCT/EP2007/058872
(87) Numéro de publication internationale: WO 2008/025745

(56) Documents cités:
- EP-A- 1 011 300
- FR-A1- 2 651 636
- FR-A1- 2 872 640
- US-A- 4 498 118

## Description

L'invention est relative au refroidissement des équipements électroniques logés dans des boîtiers ou baies placés sur des plates-formes d'accueil disposant d'une circulation forcée d'air de refroidissement pouvant être sujette à des disfonctionnements. Elle concerne notamment, les boîtiers ou baies d'appareillages électroniques embarqués à bord d'aéronef.

Le refroidissement d'un équipement électronique en boîtier s'obtient habituellement en évacuant les calories produites à l'intérieur du boîtier vers l'environnement extérieur au moyen d'un flux d'air forcé pénétrant dans le boîtier par des orifices de ventilation situés en partie inférieure servant d'embouchures, venant au contact des composants de l'équipement électronique et s'évacuant en partie supérieure du boîtier par des orifices de ventilation servant d'évents. Les possibilités d'évacuation de calories augmentent avec le débit d'air de refroidissement. Dans le cas des normes aéronautiques telles que l'Arinc 600 notamment, le diamètre et le nombre des orifices de ventilation sont contraints de manière à respecter une perte de charge pour un débit d'air normalisé, lui-même fonction de la puissance dissipée. Cette contrainte permet de répartir le flux d'air pulsé entre les différents calculateurs.

Lorsqu'un boîtier d'appareillage électronique sert également de blindage électromagnétique, ce qui est pratiquement toujours le cas pour un équipement embarqué à bord d'un aéronef, l'efficacité du blindage électromagnétique impose un diamètre réduit aux trous de ventilation dont le nombre alors est limité par les contraintes de perte de charge imposée. Ces limitations du diamètre et du nombre des trous de ventilation restreignent grandement les possibilités de refroidissement par convection naturelle et obligent très souvent à limiter la plage de température utilisable en cas de perte de la ventilation forcée.

Les équipements électroniques prévus pour être embarqués à bord d'aéronef sont habituellement mis dans des boîtiers qui sont pourvus d'orifices de ventilation d'un diamètre et d'un nombre insuffisants pour permettre un refroidissement normal par la seule convection naturelle et qui sont placés sur une boîte de répartition d'air pulsé, une sorte de sommier d'orgue, leur distribuant un flux d'air de refroidissement sous pression répondant à des spécifications précises, par exemple celles figurant dans le standard ARINC 600 portant sur la configuration des boîtiers et châssis utilisés dans les aéronefs pour loger des équipements électroniques remplaçables également dits "rackables".

Une telle disposition pose le problème difficile d'une répartition équitable de l'air pulsé disponible pour le refroidissement entre des boîtiers d'équipements disparates qui n'ont pas les mêmes besoins en refroidissement et qui, de plus, ne sont pas nécessairement présents. Elle pose également le problème, critique sur le plan de la sécurité, de la nécessaire continuité de certaines fonctions assurées par les équipements électroniques en cas de perte du flux d'air forcé de refroidissement.

En cas de perte du flux d'air forcé, le refroidissement n'est plus assuré que par une convection naturelle peu efficace en raison de la trop faible section utile des orifices de ventilation limités en diamètre et en nombre : en diamètre par les exigences du blindage électromagnétique et en nombre par la perte de charge imposée par la norme, ainsi qu'en raison du volume d'air extérieur disponible sous les boîtiers réduit à la contenance de la boîte de répartition d'air pulsé. La température des équipements augmente alors notablement, ce qui dégrade leur plage de fonctionnement en température.

La maîtrise de la température de fonctionnement d'un équipement électronique en cas de perte du flux d'air forcé est la principale limitation rencontrée lorsque l'on cherche à réduire son encombrement et à augmenter ses fonctionnalités par une densification de l'électronique car l'un et l'autre s'accompagnent toujours d'une augmentation de la production de calories au litre.

Or il n'est pas possible d'améliorer le refroidissement par convection naturelle en cas de perte du flux d'air forcé de refroidissement, en ménageant des orifices d'admission d'air supplémentaires dans les parties inférieures des boîtiers, en dehors de la boîte de répartition, car ces orifices supplémentaires d'admission vont à l'encontre du respect de l'exigence de perte de charges spécifiée, notamment celle figurant dans la norme Arinc 600.

La présente invention a pour but de remédier aux problèmes précités. Elle a notamment pour but d'améliorer le refroidissement par convection naturelle d'un boîtier d'appareillage électronique à refroidissement par air forcé pour limiter l'augmentation de température de l'appareillage électronique en cas de perte de ventilation et permettre une augmentation de la compacité et de la densité d'intégration de l'appareillage électronique.

Elle a pour objet un boîtier d'appareillage électronique comportant des orifices de ventilation par convection naturelle sur ses parois inférieure et supérieure et des rampes internes de distribution d'air alimentées en air sous pression par l'intermédiaire d'une boîte de répartition raccordée à une canalisation de circulation d'air forcée.

Avantageusement, les rampes internes de distribution d'air sont fixées de manière amovible à des orifices de distribution d'air pulsé de la boîte de répartition.

Avantageusement, les rampes internes de distribution d'air sont raccordées à des orifices de distribution d'air pulsé de la boîte de répartition munis de clapets d'obturation.

Avantageusement, les rampes internes de distribution d'air sont disposées dans la partie inférieure du boîtier.

Avantageusement, les rampes internes de distribution d'air sont disposées horizontalement.

Avantageusement, les rampes internes de distribution d'air sont alimentées en air sous pression par une boîte de répartition placée à la base de la paroi arrière du boîtier.

Avantageusement, les rampes internes de distribution d'air sont des tubes fermés à une extrémité, pourvus d'une embouchure à l'autre extrémité et percés latéralement d'un réseau d'orifices servant d'évents, répartis sur leur longueur et soufflant en direction sensiblement horizontale.

Avantageusement, lorsque le boîtier d'appareillage électronique est constitué d'une baie logeant des modules amovibles disposés côte à côte, sur la tranche, selon un alignement perpendiculaire au fond de la baie, les rampes internes de distribution d'air sont placées entre les modules et présentent des orifices latéraux servant d'évents soufflant en direction des modules.

Avantageusement, lorsque le boîtier d'appareillage électronique est constitué d'une baie logeant des modules amovibles disposés côte à côte, sur la tranche, selon un alignement perpendiculaire au fond de la baie, les rampes internes de distribution d'air sont placées horizontalement, au niveau des bords inférieurs des modules et présentent des orifices latéraux servant d'évents soufflant vers le haut, en direction des modules.

Avantageusement, lorsque le boîtier d'appareillage électronique est constitué d'une baie logeant des modules amovibles disposés côte à côte, sur la tranche, selon un alignement perpendiculaire au fond de la baie, les rampes internes de distribution d'air sont fixées aux modules perpendiculairement à la paroi arrière de la baie et raccordées, de manière amovible, à des orifices de distribution d'air pulsé de la boîte de répartition placée sur la paroi arrière de la baie.

Avantageusement, lorsque le boîtier d'appareillage électronique est constitué d'une baie comportant des connecteurs de fond de panier sur sa paroi arrière et logeant des modules amovibles enfichés dans les connecteurs de fond de panier, la boîte de répartition est placée sur la paroi arrière de la baie en dessous des connecteurs de fond de panier.

Avantageusement, lorsque le boîtier d'appareillage électronique est constitué d'une baie logeant des modules amovibles équipés individuellement d'un capot à ailettes servant de radiateur thermique et disposés côte à côte, sur la tranche, les rampes internes de distribution d'air sont fixées aux capots à ailettes des modules.

Avantageusement, lorsque le boîtier d'appareillage électronique est constitué d'une baie logeant des modules amovibles équipés individuellement d'un capot à ailettes servant de radiateur thermique et disposés côte à côte, sur la tranche, les rampes internes de distribution d'air sont fixées dans des rainures des capots à ailettes des modules.

Avantageusement, lorsque le boîtier d'appareillage électronique est constitué d'une baie logeant des modules amovibles disposés côte à côte sur la tranche et équipés individuellement d'un capot à ailettes servant de radiateur thermique, les ailettes étant configurées pour prendre une orientation verticale une fois les modules en place dans la baie, les rampes internes de distribution d'air sont fixées dans des rainures des capots en ménageant un espace libre par rapport aux fonds des rainures.

Avantageusement, lorsque le boîtier d'appareillage électronique est constitué d'une baie logeant des modules amovibles disposés côte à côte sur la tranche et équipés individuellement d'un capot à ailettes servant de radiateur thermique, les ailettes étant configurées pour prendre une orientation verticale une fois les modules en place dans la baie, les rampes internes de distribution d'air sont fixées dans des rainures des capots en ménageant un espace libre par rapport aux fonds des rainures et présentent des orifices latéraux servant d'évents soufflant vers le haut, en direction des ailettes. Un effet bénéfique est d'accélérer le flux d'air provenant de la convection naturelle et passant dans l'espace intercalaire laissé libre au fond d'une rainure par une rampe interne de distribution d'air.

Avantageusement, les rampes internes de distribution d'air peuvent être prolongées par un ou plusieurs capillaires dirigés vers les composants nécessitant un refroidissement plus efficace.

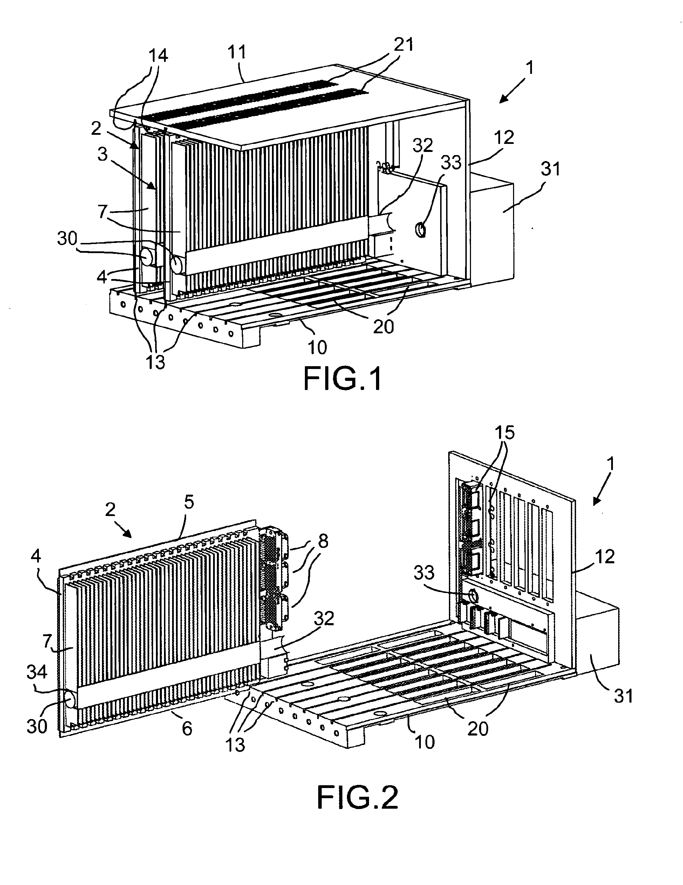

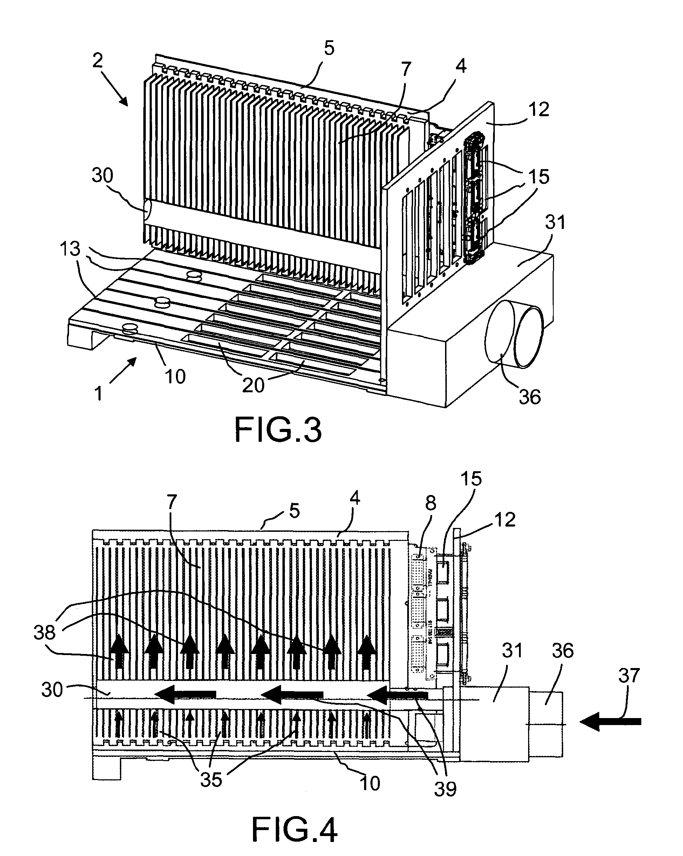

D'autres caractéristiques et avantages de l'invention ressortiront de la description ci-après d'un mode de réalisation donné à titre d'exemple. Cette description sera faite en regard du dessin dans lequel :
- une figure 1 est une vue, en perspective latérale avant, d'une baie électronique pour aéronef, conforme à l'invention, montrée partiellement démontée, avec deux modules ou unités électroniques rackables en place,
- une figure 2 est une vue, en perspective latérale avant, de la baie électronique montrée à la figure 1, illustrant le mouvement de mise en place d'un module rackable ainsi que la disposition sur un module, d'une rampe interne de distribution d'air pulsé,
- une figure 3 est une vue en perspective latérale arrière de la baie électronique montrée à la figure 2, illustrant la disposition d'une boîte de répartition d'air forcé, et
- une figure 4 est une vue de la baie montrée à la figure 1 représentée de profil, selon une coupe verticale, détaillant les trajets du flux d'air de refroidissement le long d'une paroi d'un module.

La baie électronique 1 qui va être décrite est destinée à loger un ensemble de modules électroniques 2, 3 dits rackables car enfichables dans la baie à la manière de tiroirs.

Les modules électroniques rackables 2, 3 sont de forme rectangulaire plutôt plate. Ils comportent une carte de circuit imprimé 4 à bords longitudinaux apparents constituant des arêtes longitudinales 5, 6 de guidage. Cette carte de circuit imprimé 4 supporte :
- sur l'une de ses faces ou sur ses deux faces, des composants électroniques et/ou optiques non visibles sur les figures ainsi qu'un câblage assurant les interconnexions électriques et/ou optiques des composants supportés,
- sur la ou les faces de montage des composants, un capot 7 à ailettes servant de radiateur thermique car en contact thermique étroit avec les composants électroniques et/ou optiques dégageant le plus de calories et,
- sur l'une de ses faces ou sur ses deux faces, un ensemble 8 de connecteurs électriques et/ou optiques dédiés aux raccordements des modules entre eux et avec l'environnement extérieur à la baie 1.

Les modules électroniques rackables 2, 3 peuvent avoir d'autres conformations à condition qu'ils respectent les contraintes de dimensionnement imposées par la baie 1. Notamment, leurs arêtes de guidage 5, 6 peuvent être déportées sur le capot 7 à ailettes en vue d'évacuer une partie des calories dans le châssis de la baie 1 ou sur une plaque pouvant également avoir une fonction de blindage électromagnétique fixée sur la face de la carte de circuit imprimé 4 opposée à celle recouverte du capot 7 à ailettes.

La baie électronique 1 est pourvue d'un châssis métallique comportant, à la manière habituelle, des parois latérales non visibles sur les figures, une paroi inférieure intermédiaire 10, une paroi supérieure 11 et une paroi arrière12.

Les parois inférieure intermédiaire 10 et supérieure 11 de la baie 1 supportent, en vis à vis, deux réseaux 13 et 14 de coulisses parallèles orientées perpendiculairement à la paroi arrière 12 et utilisées pour le guidage des arêtes longitudinales 5, 6 des modules 2, 3 lors des introductions, extractions et maintiens en place des modules 2, 3, côté à côte, sur la tranche, leurs cartes de circuit imprimé 4 orientées dans des plans verticaux perpendiculaires à la paroi arrière 12 de la baie 1.

La paroi arrière 12 de la baie 1 supporte, dans sa partie supérieure, un ensemble 15 de connecteurs de fond de panier s'emboîtant avec le ou les ensembles 8 de connecteurs des cartes de circuits imprimés 4 des modules 2, 3 pour assurer les raccordements des modules 2, 3 entre eux et avec l'environnement extérieur à la baie 1.

Les ailettes des capots 7 servant de radiateurs thermiques aux modules 2, 3 sont orientées perpendiculairement aux bords longitudinaux des modules 2, 3, de manière à se retrouver en position verticale une fois les modules 2, 3 en place dans la baie 1 et à faciliter leur contact avec un courant d'air de refroidissement ascendant obtenu par convection naturelle et par circulation forcée.

La convection naturelle est due à la présence d'orifices de ventilation 20, 21 dans les parois inférieure intermédiaire 10 et supérieure 11 de la baie 1.

Les orifices de ventilation 21 pratiqués dans la paroi supérieure 11 de la baie 1 sont constitués de trous de faible diamètre, de l'ordre de 3 millimètres compatibles avec les exigences d'un blindage électromagnétique. Ceux 20 pratiqués dans la paroi inférieure intermédiaire 10, qui est prévue pour séparer deux étages de modules, sont de larges fentes longitudinales car la continuité d'un blindage électromagnétique n'est pas assurée à ce niveau mais à celui du fond de la baie 1 qui n'est pas représenté et qui comporte des orifices de ventilation analogues à ceux 21 de la paroi supérieure 11 avec un diamètre faible, de l'ordre de 3 millimètres.

Les orifices de ventilation 21 répartis sur toute la surface de la paroi supérieure 11 de la baie 1, et sur toute la surface de la paroi inférieure constituant le véritable fond de la baie 1, forment des zones grillagées entre les coulisses des réseaux 13, 14 supportant les modules 2, 3, permettant une libre circulation de l'air avec des espaces de dégagement prévus au-dessus et au-dessous de la baie 1.

En plus de la ventilation par convection naturelle, les ailettes des capots 7 servant de radiateur thermique aux modules 2, 3 sont soumises à une ventilation forcée au moyen de rampes 30 de distribution d'air pulsé alimentées par l'intermédiaire d'une boîte de répartition 31 fixée à l'extérieur de la baie 1, en partie inférieure de sa paroi arrière 12, au-dessous de l'ensemble de connecteurs de fond de panier 15 et raccordée par une embouchure 36, à une conduite d'air sous pression mise à disposition de la baie 1.

Les rampes de distribution d'air pulsé 30 se présentent sous la forme de petites flûtes "piccolo" à pavillon obstrué, dont les trous de jeu servent d'évents latéraux. Elles sont disposées horizontalement, à la base des modules 2, 3, tout au long des capots 7 à ailettes, perpendiculairement à la paroi arrière 12 de la baie 1, avec leurs embouchures 32 emboîtées dans des orifices 33 de distribution d'air pulsé de la boîte de répartition 31 accessibles depuis l'intérieur de la baie 1 au travers de la paroi arrière 12, et avec leurs évents latéraux soufflant de l'air de refroidissement entre les ailettes des capots 7 des modules 2, 3.

Comme montré sur les figures, les rampes de distribution d'air pulsé 30 sont fixées aux capots 7 à ailettes des modules 2, 3, dans des rainures 34 creusées perpendiculairement aux ailettes, à proximité de leurs bases. Leurs évents latéraux, non visibles sur les figures, sont tournés vers les fonds des fentes séparant les ailettes, avec un léger décalage vers le haut pour amorcer et entretenir des courants d'air ascendants. De préférence, les rampes de distribution d'air pulsé 30 sont espacées du fond des rainures 34 pour ne pas faire obstacle aux courants d'air ascendants résultant de la convection naturelle, une amplification, par effet venturi, de ces courants d'air ascendant étant même recherchée par une orientation adéquate des évents des rampes 30.

La figure 4 illustre la répartition des courants d'air de refroidissement le long d'un capot 7 à ailettes d'un module 2, 3, résultant de la convection naturelle et de la distribution d'air pulsé par une rampe 30.

La convection naturelle provoque une nappe de courants ascendants d'air de refroidissement, dirigés de bas en haut tout le long des ailettes, selon les directions repérées par les flèches 35. Ces courants ascendants proviennent de l'espace de dégagement prévu sous la baie 1 au travers des multiples orifices de ventilation 20 pratiqués dans le fond de la baie 1 et dans les parois inférieures intermédiaires 10, et s'évacuent vers l'espace de dégagement prévu au-dessus de la baie 1 au travers des multiples orifices de ventilation 21 pratiqués dans la paroi supérieure 11 de la baie 1 et éventuellement dans des parois supérieures intermédiaires assurant des séparations entre étages supérieurs.

La distribution d'air pulsé à partir d'une canalisation raccordée depuis l'extérieur de la baie 1 à la boîte de répartition 31, rappelée sur la figure 4 par la flèche 37, provoque une nappe supplémentaire de courants d'air ascendant depuis la rampe de distribution 30 jusqu'aux sommets des ailettes, dirigés selon les sens des flèches 38 et provoqués par les souffles des évents latéraux de la rampe de distribution 30, elle-même parcourue dans le sens des flèches 39 par de l'air pulsé s'échappant de la boîte de répartition 31.

Les orifices de distribution 33 de la boîte de répartition 31 sont équipés de clapets d'obturation repoussés par les embouchures 32 des rampes 30 lors de leurs introductions dans les orifices de distribution 33, en fin des mises en place dans la baie 1 des modules 2, 3 qui les supportent. Ainsi, les orifices de distribution 33 de la boîte de répartition 31 attribués à des cases d'équipement inoccupées restent obturés évitant les déperditions d'air pulsé de refroidissement.

En outre, les rampes 30 faisant corps avec les modules 2, 3, peuvent avoir des évents latéraux à débits personnalisés en fonction des besoins locaux de refroidissement se manifestant au travers du capot 7 à ailettes. Elles peuvent également être prolongées par un ou plusieurs capillaires dirigés vers les composants nécessitant un refroidissement plus efficace.

Diverses variantes de configuration sont envisageables. Les rampes 30 peuvent être désolidarisées des capots 7 à ailettes des modules 2, 3 et avoir leurs propres supports de montage, par exemple des clips fixés à la paroi inférieure 10 de la baie 1 entre les glissières. Elles peuvent mêmes être solidaires de la boîte de répartition 31. Leurs évents latéraux peuvent prendre diverses formes y compris celles de fentes.

## Revendications

1. Boîtier d'appareillage électronique (1) à refroidissement par convection naturelle et circulation d'air forcée, comportant des orifices de ventilation (20, 21) par convection naturelle sur ses parois inférieure (10) et supérieure (11), et constitué d'une baie (1) logeant des modules amovibles (2, 3) disposés côte à côte, sur la tranche, selon un alignement perpendiculaire à la paroi arrière (12) de la baie (1), **caractérisé en ce qu'**il comporte des rampes internes (30) de distribution d'air, une par module, les rampes étant disposées horizontalement, dans la partie inférieure du boîtier et alimentées en air sous pression par l'intermédiaire d'une boîte de répartition (31) raccordée à une canalisation de circulation d'air forcée (37) disposée à l'arrière (12) de la baie, provoquant une nappe de courants d'air ascendants depuis chaque rampe.

2. Boîtier selon la revendication 1, dans lequel les rampes internes (30) de distribution d'air sont fixées de manière amovible à des orifices (33) de distribution d'air pulsé de la boîte de répartition (31).

3. Boîtier selon la revendication 1, dans lequel les rampes internes (30) de distribution d'air sont raccordées à des orifices (33) de distribution d'air pulsé de la boîte de répartition (31) munis de clapets d'obturation.

4. Boîtier selon la revendication 1, dans lequel la boîte de répartition (31) est placée à la base de la paroi arrière (12) du boîtier (1).

5. Boîtier selon la revendication 1, dans lequel les rampes internes (30) de distribution d'air sont des tubes fermés à une extrémité, pourvu d'une embouchure (32) à l'autre extrémité et percés latéralement d'un réseau d'orifices servant d'évents, répartis sur leur longueur et soufflant en direction sensiblement horizontale.

6. Boîtier selon la revendication 5, dans lequel les rampes internes (30) de distribution d'air sont placées entre les modules (2, 3), leurs orifices latéraux servant d'évents soufflant en direction des modules (2, 3).

7. Boîtier selon la revendication 6, **caractérisé en ce que** les rampes internes (30) de distribution d'air sont disposées horizontalement, au niveau des bords inférieurs des modules (2, 3), leurs orifices latéraux servant d'évents soufflant vers le haut, en direction des modules (2, 3).

8. Boîtier selon la revendication 1, dans lequel les rampes internes (30) de distribution d'air sont fixées aux modules (2, 3) perpendiculairement à la paroi arrière (12) de la baie (1) et raccordées, de manière amovible, à des orifices (33) de distribution d'air pulsé de la boîte de répartition (31) placée sur la paroi arrière (12) de la baie (1).

9. Boîtier selon la revendication 8, la baie (1) comportant des connecteurs de fond de panier (15) sur sa paroi arrière (12) et logeant des modules amovibles (2, 3) enfichés dans les connecteurs de fond de panier(15), **caractérisé en ce que** la boîte de répartition (31) est placée sur la paroi arrière de la baie en dessous des connecteurs de fond de panier (15).

10. Boîtier selon la revendication 9, logeant des modules amovibles (2, 3) pourvus individuellement d'un capot (7) à ailettes servant de radiateur thermique, **caractérisé en ce que** les rampes internes (30) de distribution d'air sont fixées aux capots (7) à ailettes des modules (2, 3).

11. Boîtier selon la revendication 10, dans lequel les rampes internes (30) de distribution d'air sont fixées dans des rainures (34) des capots (7) à ailettes des modules (2, 3).

12. Boîtier selon la revendication 11, logeant des modules amovibles (2, 3) pourvus individuellement de capot (7) à ailettes, les ailettes étant configurées pour prendre une orientation verticale une fois les modules (2, 3) en place dans le boîtier (1), **caractérisé en ce que** les rampes internes (30) de distribution d'air sont espacées du fond des rainures (34) dans lesquelles elles sont fixées.

13. Boîtier selon la revendication 12, **caractérisé en ce que** les rampes internes (30) de distribution d'air sont percées latéralement d'un réseau d'orifices répartis sur leur longueur et soufflant vers le haut, en direction des ailettes, de manière à accélérer le flux d'air provenant de la convection naturelle, passant dans l'espace intercalaire laissé libre au fond d'une rainure (34) par une rampe interne (30) de distribution d'air.

14. Boîtier selon la revendication 1, **caractérisé en ce que** les rampes internes (30) sont prolongées par un ou plusieurs capillaires dirigés vers les composants nécessitant un refroidissement plus efficace.

## Claims

1. An electronic equipment casing (1) with cooling by natural convection and forced air circulation, comprising holes (20, 21) for ventilation by natural convection on its lower (10) and upper (11) walls, and constituted by a rack (1) accommodating detachable modules (2, 3) arranged side by side, on an edge, in an alignment perpendicular to the rear wall (12) of the rack (1), **characterised in that** it comprises internal ramps (30) for air distribution, one per module, said ramps being arranged horizontally, in the lower section of the casing and supplied with pressurised air by means of a distribution unit (31) connected to a forced air circulation pipe (37) arranged at the rear (12) of the rack, initiating a layer of air currents ascending from each ramp.

2. The casing according to claim 1, wherein the internal ramps (30) for air distribution are fixed in a detachable manner to holes (33) for the distribution of air pulsed from the distribution unit (31).

3. The casing according to claim 1, wherein the internal ramps (30) for air distribution are connected to holes (33) for the distribution of air pulsed from the distribution unit (31) provided with plug flaps.

4. The casing according to claim 1, wherein the distribution unit (31) is placed at the base of the rear wall (12) of the casing (1).

5. The casing according to claim 1, wherein the internal ramps (30) for air distribution are tubes closed at one end, provided with a nozzle (32) at the other end and laterally drilled with a set of holes acting as vents, distributed lengthwise and blowing in an essentially horizontal direction.

6. The casing according to claim 5, wherein the internal ramps (30) for air distribution are placed between the modules (2, 3), their lateral holes acting as vents blowing towards the modules (2, 3).

7. The casing according to claim 6, **characterised in that** the internal ramps (30) for air distribution are arranged horizontally, at the lower edges of the modules (2, 3), their lateral holes acting as vents blowing upwards towards the modules (2, 3).

8. The casing according to claim 1, wherein the internal ramps (30) for air distribution are fixed to the modules (2, 3) perpendicular to the rear wall (12) of the rack (1) and connected in a detachable manner to the holes (33) for the distribution of air pulsed from the distribution unit (31) placed on the rear wall (12) of the rack (1).

9. The casing according to claim 8, the rack (1) comprising motherboard (15) connectors on its rear wall (12) and accommodating detachable modules (2, 3) plugged into said motherboard connectors (15), **characterised in that** the distribution unit (31) is placed on the rear wall of the rack below the motherboard connectors (15).

10. The casing according to claim 9, accommodating detachable modules (2, 3) each provided with a cooling vane cover (7) acting as a thermal radiator, **characterised in that** the internal ramps (30) for air distribution are fixed to the cooling vane covers (7) of the modules (2, 3).

11. The casing according to claim 10, wherein the internal ramps (30) for air distribution are fixed in the grooves (34) of the cooling vane covers (7) of the modules (2, 3).

12. The casing according to claim 11, accommodating detachable modules (2, 3) each provided with a cooling vane cover (7), the vanes being configured to follow a vertical orientation once the modules (2, 3) are in place inside the casing (1), **characterised in that** the internal ramps (30) for air distribution are separated from the base of the grooves (34) in which they are mounted.

13. The casing according to claim 12, **characterised in that** the internal ramps (30) for air distribution are laterally drilled with a set of holes distributed lengthwise and blowing upwards, towards the vanes, so as to accelerate the air flow originating from natural convection, passing into the space left free at the base of a groove (34) by an internal ramp (30) for air distribution.

14. The casing according to claim 1, **characterised in that** the internal ramps (30) are extended by one or more capillaries directed towards those components that require more efficient cooling.

## Patentansprüche

1. Elektronisches Gerätegehäuse (1) mit Kühlung durch natürliche Konvektion und Zwangsluftumwälzung, umfassend Löcher (20, 21) zum Lüften durch natürliche Konvektion an der unteren (10) und der oberen (11) Wand davon, und gebildet durch einen Baugruppenträger (1), der nebeneinander angeordnete entfernbare Module (2, 3) auf dem Rand in einer Ausrichtung lotrecht zur hinteren Wand (12) des Baugruppenträgers (1) stehend aufnimmt, **dadurch gekennzeichnet, dass** es interne Rampen (30), eine pro Modul, zur Luftverteilung umfasst, wobei die Rampen horizontal im unteren Teil des Gehäuses angeordnet sind und mittels einer Verteilungseinheit (31) mit Druckluft versorgt werden, die an einen Zwangsluftumwälzkanal (37) angeschlossen ist, der im hinteren Teil (12) des Baugruppenträgers angeordnet ist, um zu bewirken, dass eine Schicht von Luftströmen von jeder Rampe aufsteigt.

2. Gehäuse nach Anspruch 1, wobei die internen Rampen (30) zur Luftverteilung lösbar in Löchern (33) für die Verteilung von Luft befestigt sind, die von der Verteilungseinheit (31) pulsiert wird.

3. Gehäuse nach Anspruch 1, wobei die internen Rampen (30) zur Luftverteilung mit mit Verschlussklappen versehenen Löchern (33) für die Verteilung von Luft verbunden sind, die von der Verteilungseinheit (31) pulsiert wird.

4. Gehäuse nach Anspruch 1, wobei die Verteilungseinheit (31) an der Basis der hinteren Wand (12) des Gehäuses (1) platziert ist.

5. Gehäuse nach Anspruch 1, wobei die internen Rampen (30) zur Luftverteilung Röhren sind, die an einem Ende geschlossen, am anderen Ende mit einer Düse (32) versehen und seitlich mit einem Netzwerk von Löchern durchbohrt sind, die als Lüftungen wirken, über die Länge verteilt sind und in einer im Wesentlichen horizontalen Richtung blasen.

6. Gehäuse nach Anspruch 5, wobei die internen Rampen (30) zur Luftverteilung zwischen den Modulen (2, 3) platziert sind und ihre lateralen Löcher als Lüftungen wirken, die in Richtung der Module (2, 3) blasen.

7. Gehäuse nach Anspruch 6, **dadurch gekennzeichnet, dass** die internen Rampen (30) zur Luftverteilung horizontal an den unteren Rändern der Module (2, 3) angeordnet sind und ihre lateralen Löcher als aufwärts in Richtung der Module (2, 3) blasende Lüftungen wirken.

8. Gehäuse nach Anspruch 1, wobei die internen Rampen (30) zur Luftverteilung an den Modulen (2, 3) lotrecht zur hinteren Wand (12) des Baugruppenträgers (1) befestigt und lösbar mit den Löchern (33) zur Verteilung von Luft verbunden sind, die von der Verteilungseinheit (31) pulsiert wird, die an der hinteren Wand (12) des Baugruppenträgers (1) platziert ist.

9. Gehäuse nach Anspruch 8, wobei der Baugruppenträger (1) an seiner hinteren Wand (12) Steckverbinder für eine Hauptplatine (15) umfasst und lösbare Module (2, 3) aufnimmt, die in die Steckverbinder (15) der Hauptplatine eingesteckt sind, **dadurch gekennzeichnet, dass** die Verteilungseinheit (31) an der hinteren Wand des Baugruppenträgers unterhalb der Steckverbinder (15) der Hauptplatine platziert ist.

10. Gehäuse nach Anspruch 9, das lösbare Module (2, 3) aufnimmt, die jeweils mit einer als Temperaturstrahler ausgebildete Flügelabdeckung (7) versehen sind, **dadurch gekennzeichnet, dass** die internen Rampen (30) zur Luftverteilung an den Flügelabdeckungen (7) der Module (2, 3) befestigt sind.

11. Gehäuse nach Anspruch 10, wobei die internen Rampen (20) zur Luftverteilung in den Nuten (34) der Flügelabdeckungen (7) der Module (2, 3) befestigt sind.

12. Gehäuse nach Anspruch 11, das lösbare Module (2, 3) aufnimmt, die jeweils mit einer Flügelabdeckung (7) versehen sind, wobei die Flügel so konfiguriert sind, dass sie eine vertikale Orientierung einnehmen, wenn die Module (2, 3) im Gehäuse (1) platziert sind, **dadurch gekennzeichnet, dass** die internen Rampen (30) zur Luftverteilung vom Boden der Nuten (34) beabstandet sind, in denen sie montiert sind.

13. Gehäuse nach Anspruch 12, **dadurch gekennzeichnet, dass** die internen Rampen (30) zur Luftverteilung seitlich von einem über ihre Länge verteilten Netzwerk von Löchern durchbohrt sind, die nach oben in Richtung der Flügel blasen, um den von der natürlichen Konvektion kommenden Luftstrom in dem Raum zu beschleunigen, der am Boden einer Nut (34) von einer internen Rampe (30) zur Luftverteilung freigelassen wird.

14. Gehäuse nach Anspruch 1, **dadurch gekennzeichnet, dass** die internen Rampen (30) durch eine oder mehrere Kapillaren verlängert werden, die in Richtung auf die Komponenten gerichtet sind, die eine effizientere Kühlung erfordern.
